# EUROPEAN PATENT APPLICATION

(11) **EP 4 791 150 A1**
(43) Date of publication of application: **12.08.2026**
(21) Application number: 25804967.5
(22) Date of filing: 31.03.2025
(51) Int. Cl.: H10F 19/00

(54) **IBC CELL, IBC CELL ASSEMBLY, AND PRODUCTION METHOD**

(30) Priority: 29.10.2024 CN 202411514123
(71) Applicant: Opes Solutions (Changzhou) Co., Ltd., Changzhou, Jiangsu 213000 (CN)
(72) Inventor: TANG, Hong-Shiang, Changzhou, Jiangsu 213000 (CN); HSU, Fan-Wei, Changzhou, Jiangsu 213000 (CN); HÄNDEL, Robert Christoph, 10115 Berlin (DE)
(74) Representative: Eisenführ Speiser
(86) International application number: PCT/CN2025/086241
(87) International publication number: WO 2026/091403

(57) **Abstract**

An IBC cell, an IBC cell assembly, and a production method are provided, and belong to the technical field of solar cells. An IBC cell body includes a first cell segment, a rectangular transition zone and a second cell segment. The first cell segment and the second cell segment are distributed on two sides of the rectangular transition zone respectively and arranged mirror-symmetrically arranged, the length of the rectangular transition zone in a transverse direction is a first preset distance 2d, and backlight sides of the first cell segment and the second cell segment are provided with positive electrodes and a negative electrodes. In the IBC cell assembly, first cell row units and second cell row units arranged alternately in a longitudinal direction, the first cell row unit includes N IBC cell bodies arranged in the transverse direction, and the second cell row unit includes N-1 IBC cell bodies rotated by 180° and arranged in the transverse direction, and includes the first cell segment and the second cell segment that are rotated by 180° and arranged on two end sides of the N-1 IBC cell bodies respectively.

## Description

### TECHNICAL FIELD

The present disclosure relates to the technical field of solar cells, and in particular to an interdigitated back contact (IBC) cell, an Interdigitated Back Contact (IBC) cell assembly and a production method.

### BACKGROUND

During operation of solar cell assembly, when one or some of cells are shaded, an output voltage of other cells in serial connection with shaded cells will be consumed by the shaded cells, and such energy consumption may cause local breakdown of PN junctions of the cells, resulting in local overheating, which is a hot spot effect. In order to prevent the solar cells from being damaged by the hot spot effect, a common solution is to add bypass diodes on the basis of an original circuit, and when light is not blocked, each diode is in a reverse bias voltage, and each cell generates electrical energy. When one cell is shaded, the shaded cell stops generating the electrical energy and becomes a high-resistance resistor, and meanwhile other cells induces the shaded cell into a reverse bias voltage, causing the diodes connected to two ends of the shaded cell conducting, and thus the current that would otherwise flow through the shaded cells is shunted by the diodes.

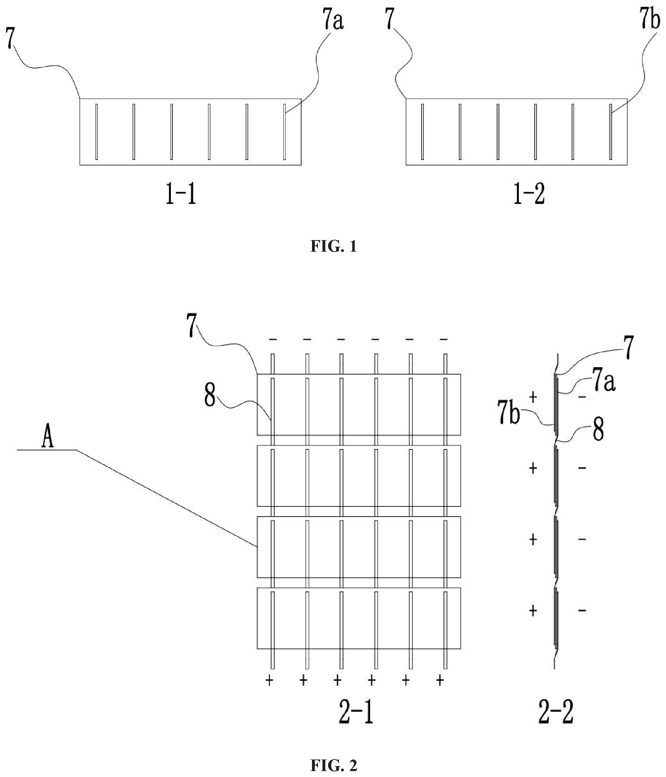

In the art known to the inventors, FIG. 1 shows a conventional cell, which is mainly characterized in that a positive electrode and a negative electrode of the conventional cell 7 are separately located on two sides of the cell, where FIG. 1-1 is a front view, FIG. 1-2 is a rear view, and main grid lines are then printed on the two sides, for example, main grid lines include positive electrode main grid lines 7a and negative electrode main grid lines 7b in a conventional cell shown in FIG. 1. If the conventional cells 7 are connected by means of interconnection ribbons 8, an appearance thereof is as shown in FIG. 2, where FIG. 2-1 is a rear view, FIG. 2-2 is a side view, the interconnection ribbons 8 are soldered onto the positive electrode main grid lines 7a on a front side of a first cell and then onto the negative electrode main grid lines 7b on a rear side of a second cell, forming a cell string A by repeating the above-described operations.

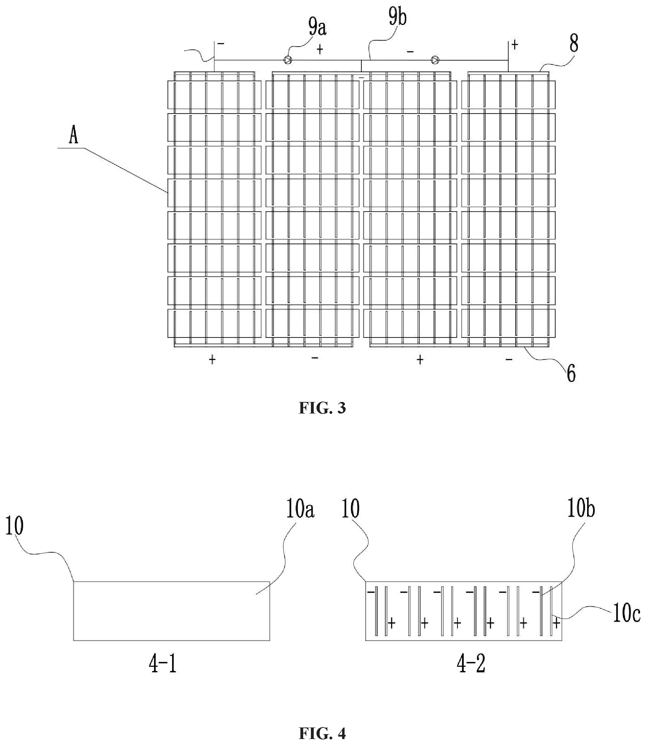

If the positive and negative terminals of the cell strings A are connected in series, as shown in FIG. 3, a circuit of a photovoltaic assembly can be formed by connecting four cell strings A in series by means of five busbars 6. However, a bypass diode 9a and a bypass diode circuit 9b are typically added to reduce shading loss caused by hot spots or shadows.

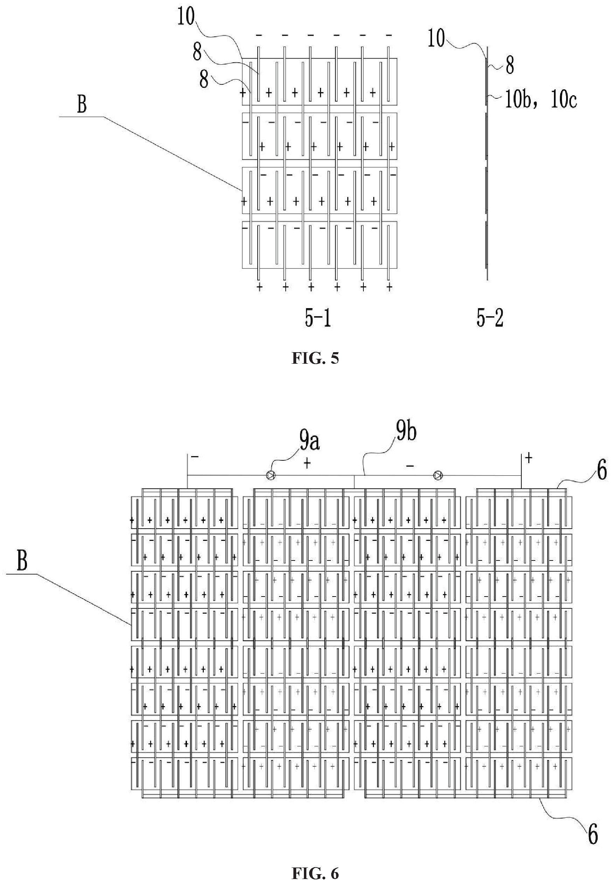

In recent years, an interdigitated back contact (IBC) cell technology has gained increasing attention because a front side of a cell has no main grid lines. In the art known to the inventors, as shown in FIG. 4, the electrodes are all arranged on a back side of a conventional IBC cell body 10, and a front side 10a of the conventional IBC cell has no main grid lines, so that optical loss caused by the shading of busbars can be reduced well, and better aesthetic appearance can be obtained. FIG. 4-1 is a front view, FIG. 4-2 is a rear view, and the serial connection of the conventional IBC cell bodies 10 is easier than that of the conventional cells 7. As shown in FIG. 5, FIG. 5-1 is a rear view, and FIG. 5-2 is a side view. The serial connections between positive and negative electrodes on the back sides of the cells are all directly performed by means of the interconnection ribbons 8, the interconnection ribbons 8 are soldered first onto a negative electrode main grid line 10b of the first cell, extending outside the cell to form a negative terminal, another interconnection ribbon 8 is then soldered onto a positive electrode main grid line 10c on the rear side of the first cell to extend to the negative electrode main grid line 10b of the second cell, forming an IBC cell string B can by repeating the above-described operations.

If positive and negative terminals of the cell strings B are connected in series, as shown in FIG. 6, a circuit of the photovoltaic assembly can be formed by connecting four cell strings B in series by means of five busbars 6. However, similar to the conventional cell assembly, the IBC cells are still shaded by hot spots or shadows, and therefore a bypass diode 9a and a bypass diode circuit 9b are also typically added to reduce shading loss caused by the hot spots or shadows.

Although the electrodes are disposed on the back side in the process of producing the cell string according to the conventional IBC cell technology, it still needs to solder the cells one by one to form the string, arrange the cell strings, and then solder the cell strings together by means of the busbars. The IBC cell technology has not large differences from the production method for conventional cells, and the production efficiency of the IBC cell technology is not significantly improved. Moreover, compared with the conventional cells, a conventional IBC cell assembly does not improve the hot spots and power loss caused by shading.

### SUMMARY

An objective of the present disclosure is to solve the above technical problem, and provide an IBC cell, an IBC cell assembly and a production method.

To achieve the above objective, the present disclosure provides the following solutions: The present disclosure provides an IBC cell, which includes: an IBC cell body (1), and positive electrodes and negative electrodes that are disposed on a backlight surface of the IBC cell body (1). The IBC cell body (1) includes a first cell segment (2), a rectangular transition zone and a second cell segment (3), the first cell segment (2) and the second cell segment (3) are distributed on two sides of the rectangular transition zone respectively and arranged mirror-symmetrically with respect to the rectangular transition zone as an axis of symmetry, a length of the rectangular transition zone in a transverse direction is a first preset distance 2d, the positive electrodes and the negative electrodes are disposed on backlight surfaces of the first cell segment (2) and the second cell segment (3), and each of the positive electrodes and the negative electrodes has main grid lines. The first preset distance 2d is 2 times of a distance between a main grid line of one of the positive electrodes and a main grid line of one of the negative electrodes adjacent to the one of the positive electrodes.

The present disclosure further provides an IBC cell assembly having the above IBC cell. The IBC cell assembly includes an IBC cell array (4). The IBC cell array (4) includes first cell row units and second cell row units arranged alternately in a longitudinal direction. Each of the first cell row units includes N IBC cell bodies (1) arranged in the transverse direction, where N is a positive integer greater than 2. Each of the second cell row units includes: N-1 IBC cell bodies (1) rotated by 180° and arranged in the transverse direction; and the first cell segment (2) and the second cell segment (3) that are rotated by 180° and arranged on two end sides of the N-1 IBC cell bodies (1) respectively. A distance between an IBC cell body (1) and the first cell segment (2) or the second cell segment (3) in the transverse direction is a second preset distance d, and a distance between IBC cell bodies (1) in the transverse direction is a first preset distance 2d.

The present disclosure further provides an IBC cell assembly having the above IBC cells. The IBC cell assembly includes an IBC cell array (4). The IBC cell array (4) includes first cell row units and second cell row units arranged alternately in a longitudinal direction. Each of the first cell row units includes: N IBC cell bodies (1) arranged in a transverse direction; and the first cell segment (2) or the second cell segment (3) arranged on one of two end sides of the N IBC cell bodies (1), where N is a positive integer greater than 2. Each of the second cell row units includes: N IBC cell bodies (1) rotated by 180° and arranged in the transverse direction; and the first cell segment (2) or the second cell segment (3) rotated by 180° and arranged on an other of two end sides of the N IBC cell bodies (1). A distance between an IBC cell body (1) and the first cell segment (2) or the second cell segment (3) in the transverse direction is a second preset distance d, and a distance between IBC cell bodies (1) in the transverse direction is a first preset distance 2d.

In an implementation, each of the positive electrodes includes: first positive electrode segments disposed in the first cell row units; and second positive electrode segments disposed in the second cell row units adjacent to the first cell row units. Each of the negative electrodes includes: first negative electrode segments in the first cell row units; and second negative electrode segments disposed in the second cell row units adjacent to the first cell row units. Each of the first positive electrode segments includes: a plurality of first positive electrode connection points for connection with soldering wires; and first positive electrode main grid lines for connecting adjacent first positive electrode connection points. Each of the first negative electrode segments includes: a plurality of first negative electrode connection points for connection with soldering wires; and first negative electrode main grid lines for connecting adjacent first negative electrode connection points. Each of the second positive electrode segments includes: a plurality of second positive electrode connection points for connection with soldering wires; and second positive electrode main grid lines for connecting adjacent second positive electrode connection points. Each of the second negative electrode segments includes: a plurality of second negative electrode connection points for connection with soldering wires; and second negative electrode main grid lines for connecting adjacent second negative electrode connection points. Each of the first positive electrode main grid lines and a corresponding one of the second negative electrode main grid lines coincide in extension directions thereof. Each of the first negative electrode main grid lines and a corresponding one of the second positive electrode main grid lines coincide in extension directions thereof.

In an implementation, the IBC cell assembly further includes busbars (6) disposed at an upper end and a lower end of the IBC cell array (4) in the transverse direction.

In an implementation, with in the IBC cell assembly, the busbars (6) are soldered onto the first cell row units and the second cell row units to form a circuit by roll-soldering a carrier film (5) with soldering wires (5a).

In an implementation, by means of the soldering wires (5a) in the carrier film (5), a third positive electrode connection busbar and a fourth negative electrode connection busbar are soldered together, or a third negative electrode connection busbar and a fourth positive electrode connection busbar are soldered together.

In an implementation, by means of the soldering wires (5a) in the carrier film (5), the third positive electrode connection busbar and the fourth negative electrode connection busbar are soldered together, and the third negative electrode connection busbar and the fourth positive electrode connection busbar are soldered together, and some of the soldering wires (5a) which causes short circuiting are removed by laser.

The present disclosure further provides a production method for an IBC cell assembly having the above IBC cell, the production method being characterized by including:
S1, symmetrically separating a conventional IBC cell along a longitudinal centerline into a first cell segment (2) and a second cell segment (3), moving the first cell segment (2) and the second cell segment (3) respectively toward two sides by a distance d, such that a distance between the first cell segment (2) and the second cell segment (3) in a transverse direction is a first preset distance 2d, and connecting the first cell segment (2) and the second cell segment (3) in series to form an IBC cell body (1), where the first preset distance 2d is 2 times of the distance between a main grid line of one of positive electrodes and a main grid line of one of negative electrodes adjacent to the one of the positive electrodes;
S2, arranging N IBC cell bodies (1) in the transverse direction to form a first cell row unit, where N is a positive integer greater than 2; arranging, in the transverse direction, N-1 IBC cell bodies (1) rotated by 180°, and arranging, in the transverse direction, the first cell segment (2) and the second cell segment (3) that are rotated by 180° and arranged on two end sides of the N-1 IBC cell bodies (1) respectively to form a second cell row unit; arranging the first cell row unit and the second cell row unit alternately in a longitudinal direction to form an IBC cell array, where a distance between the IBC cell body (1) and the first cell segment (2) or the second cell segment (3) in the transverse direction is a second preset distance d, and a distance between IBC cell bodies (1) in the transverse direction is the first preset distance 2d;
S3, placing busbars (6) at an upper end and a lower end of the IBC cell array (4) respectively; and
S4, placing a carrier film (5) with soldering wires (5a) on the IBC cell array (4), and roll-soldering the soldering wires (5a) and the carrier film (5) to be fixed onto electrodes of the cells and to be attached to back sides of the cells.

The present disclosure further provides a production method for an IBC cell assembly having the above IBC cell, the production method being characterized by including:
S1, symmetrically separating a conventional IBC cell along a longitudinal centerline into a first cell segment (2) and a second cell segment (3), moving the first cell segment (2) and the second cell segment (3) respectively toward two sides by a distance d, such that a distance between the first cell segment (2) and the second cell segment (3) in a transverse direction is a first preset distance 2d, and connecting the first cell segment (2) and the second cell segment (3) in series to form an IBC cell body (1), where the first preset distance 2d is 2 times of a distance between a main grid line of one of positive electrodes and a main grid line of one of negative electrodes adjacent to the one of the positive electrodes;
S2, arranging N IBC cell bodies (1) in the transverse direction, and arranging, in the transverse direction, the first cell segment (2) or the second cell segment (3) arranged on one of two end sides of the N IBC cell bodies (1) to form a first cell row unit, where N is a positive integer greater than 2; arranging, in the transverse direction, N IBC cell bodies (1) rotated by 180°, and arranging, in the transverse direction, the first cell segment (2) or the second cell segment (3) rotated by 180° and arranged on an other of two end sides of the N IBC cell bodies (1) to form a second cell row unit; arranging the first cell row unit and the second cell row unit alternately in a longitudinal direction to form an IBC cell array, where a distance between the IBC cell body (1) and the first cell segment (2) or the second cell segment (3) in the transverse direction is a second preset distance d, and a distance between IBC cell bodies (1) in the transverse direction is the first preset distance 2d;
S3, placing busbars (6) at an upper end and a lower end of the IBC cell array (4) respectively; and
S4, placing a carrier film (5) with soldering wires (5a) on the IBC cell array (4), and roll-soldering the soldering wires (5a) and the carrier film (5) to be fixed onto electrodes of the cells and to be attached to back sides of the cells.

In an implementation, in S4, some of the soldering wires (5a) causing short circuiting are removed by laser.

In an implementation, in S4, the IBC cell array (4) is conveyed to a heated transport platform with foam-coated hot-pressing rollers.

The present disclosure achieves the following technical effects compared with the prior art:

The IBC cell provided in the present disclosure can be divided into two cell segments, the two cell segments are then soldered in series, a half IBC cell has a constant open-circuit voltage and a current that is 1/2 of a current of the entire IBC cell. According to Joule's law, the internal loss of the half IBC cell is reduced to 1/4 of the internal loss of the entire IBC cell, and thus the overall output power and efficiency of the IBC cell assembly are improved. According to the present disclosure, by soldering the carrier film, the cells of an entire IBC cell assembly can be directly connected to complete a circuit of the entire assembly without soldering the cells one by one remarkably improving the efficiency. The IBC cell assembly in the present disclosure employs a misaligned matrix layout, so that hot spots and power loss caused by shading the cells can be effectively reduced without additional bypass diodes.

### BRIEF DESCRIPTION OF THE DRAWINGS

In order to illustrate the technical solutions in the embodiments of the present disclosure more clearly, a brief introduction to the accompanying drawings required for the embodiments will be provided below. Obviously, the accompanying drawings in the following description are merely some of the embodiments of the present disclosure, and those of ordinary skill in the art can also obtain other drawings according to these drawings without creative effort.
FIG. 1 is a front view and a rear view of a conventional cell;
FIG. 2 is a rear view and a side view of conventional cells soldered into a string;
FIG. 3 is a structural schematic diagram of a photovoltaic assembly composed of conventional cells;
FIG. 4 is a front view and a rear view of a conventional IBC cell;
FIG. 5 is a rear view and a side view of conventional IBC cells soldered into a string;
FIG. 6 is a structural schematic diagram of a photovoltaic assembly composed of conventional IBC cells;
FIG. 7 is a structural schematic diagram of an IBC cell according to one or more embodiments of the present disclosure;
FIG. 8 is a rear view of an IBC cell assembly according to one or more embodiments of the present disclosure;
FIG. 9 is a rear view of the IBC cell assembly according to one or more embodiments of the present disclosure;
FIG. 10 is a structural schematic diagram of a carrier film with soldering wires according to one or more embodiments of the present disclosure;
FIG. 11 is a front schematic view of an IBC cell assembly before some of the soldering wires are cut away by laser according to one or more embodiments of the present disclosure;
FIG. 12 is a schematic view of an IBC cell assembly after some of the soldering wires are cut away by laser according to one or more embodiments of the present disclosure;
FIG. 13 is a front view of an IBC cell assembly according to one or more embodiments of the present disclosure;
FIG. 14 is a flow chart of a production method for an IBC cell assembly according to one or more embodiments of the present disclosure;
FIG. 15 is a flow chart of a production method for an IBC cell assembly according to one or more embodiments of the present disclosure.

Reference numerals: 1. IBC cell body; 2. First cell segment; 3. Second cell segment; 4. IBC cell array; 5. Carrier film; 5a. Soldering wire; 6. Busbar; 7. Conventional cell; 7a. Positive electrode main grid line of conventional cell; 7b. Negative electrode main grid line of conventional cell; 8. Interconnection ribbon; 9a. Bypass diode; 9b. Bypass diode circuit; 10. Conventional IBC cell body; 10a. Front side of conventional IBC cell; 10b. Negative electrode main grid line of conventional IBC cell; 10c. Positive electrode main grid line of conventional IBC cell; 12. First cell; 13. Second cell; and 14. Third cell.

### DETAILED DESCRIPTION OF THE EMBODIMENTS

The technical solutions in the embodiments of the present disclosure will be clearly and completely described below in conjunction with the accompanying drawings in the embodiments of the present disclosure. Apparently, the embodiments described are merely some rather than all of the embodiments of the present disclosure. Based on the embodiments in the present disclosure, all other embodiments obtained by those of ordinary skill in the art without creative effort belong to the scope of protection of the present disclosure.

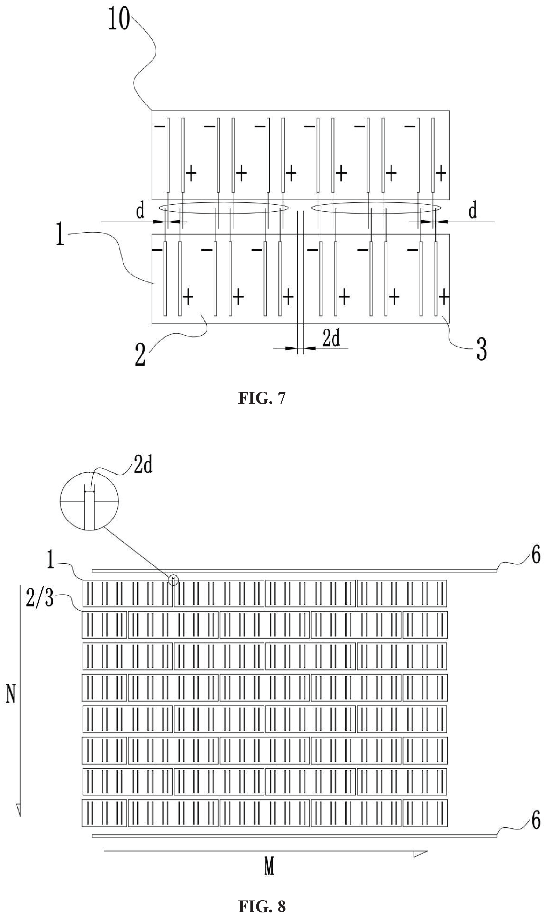

Referring to FIGs. 1-15, where FIGs. 1-6 show a conventional art, and FIGs. 7 -15 show technical solutions provided by the present disclosure:

### Embodiment 1

As shown in FIG. 7, this embodiment provides an IBC cell, which includes: an IBC cell body 1, and positive electrodes and negative electrodes that are disposed on a backlight surface of the IBC cell body 1; the IBC cell body 1 includes a first cell segment 2, a rectangular transition zone and a second cell segment 3, the first cell segment 2 and the second cell segment 3 are distributed on two sides of the rectangular transition zone and are arranged mirror-symmetrically with respect to the rectangular transition zone as the axis of symmetry, the length of the rectangular transition zone in a transverse direction is a first preset distance 2d, each of the backlight surfaces of the first cell segment 2 and the second cell segment 3 are provided with the positive electrodes and the negative electrodes, and each of the positive electrodes and the negative electrodes has main grid lines; the first preset distance 2d is two times of a distance between a main grid line of the positive electrode and a main grid line of the negative electrode adjacent to the positive electrode.

In an implementation, the IBC cell body 1 of the present disclosure may be designed and produced directly.

### Embodiment 2

This embodiment provides an IBC cell assembly, the IBC cell assembly includes an IBC cell array 4, where the IBC cell array 4 includes first cell row units and second cell row units, and the first cell row units and the second cell row units are arranged alternately in a longitudinal direction. The first cell row unit includes N IBC cell bodies 1 of Embodiment 1 arranged in the transverse direction, N is a positive integer greater than 2. The second cell row unit includes: N-1 IBC cell bodies 1 rotated by 180° and arranged in the transverse direction; and the first cell segment 2 and the second cell segment 3 that are rotated by 180° and arranged on two end sides of the N-1 IBC cell bodies 1 respectively. A distance between the IBC cell body 1 and the first cell segment 2 or the second cell segment 3 in the transverse direction is a second preset distance d, and a distance between the IBC cell bodies 1 in the transverse direction is a first preset distance 2d. As shown in FIG. 8, the IBC cell bodies 1 and the first cell segments 2 or the second cell segments 3 are arranged alternately to form a first column. It should be noted that the first cell row unit may be an odd-numbered row of cells in the figure or an even-numbered row of cells in FIG. 8, which is not limited in the present disclosure.

In an implementation, by adjusting the number and an arrangement manner of the IBC cell bodies 1, an voltage and a current of the IBC cell assembly can be adjusted to reach a desired voltage and a desired current. As shown in FIG. 8, by increasing the number M of the cells in the column, a current of the IBC cell assembly can be increased, and by increasing the number N of the columns, a voltage of the IBC cell assembly can be increased.

In an implementation, the IBC cell assembly includes positive electrodes and negative electrodes disposed on backlight surfaces of the IBC cell bodies 1, the first cell segments 2 and the second cell segments 3. The positive electrode includes a first positive electrode segment disposed in the first cell row unit, and a second positive electrode segment disposed in the second cell row unit adjacent to the first cell row unit. The negative electrode includes a first negative electrode segment in the first cell row unit, and a second negative electrode segment disposed in the second cell row unit adjacent to the first cell row unit. The first positive electrode segment includes multiple first positive electrode connection points for connection with soldering wires, and first positive electrode main grid lines for connecting adjacent first positive electrode connection points. The first negative electrode segment includes multiple first negative electrode connection points for connection with soldering wires, and first negative electrode main grid lines for connecting adjacent first negative electrode connection points. The second positive electrode segment includes multiple second positive electrode connection points for connection with soldering wires, and second positive electrode main grid lines for connecting adjacent second positive electrode connection points. The second negative electrode segment includes multiple second negative electrode connection points for connection with soldering wires, and second negative electrode main grid lines for connecting adjacent second negative electrode connection points. The first positive electrode main grid line and the second negative electrode main grid line coincide in an extension directions thereof. The first negative electrode main grid line and the second positive electrode main grid line coincide in the extension directions thereof.

In an implementation, the IBC cell assembly further includes busbars 6 disposed at the upper end and the lower end of the IBC cell array 4 in the transverse direction, respectively.

In an implementation, in the IBC cell assembly, the busbars 6 are soldered onto the first cell row units and the second cell row units to form a circuit by roll-soldering the carrier film 5 with the soldering wires 5a.

In an implementation, by means of the soldering wires 5a in the carrier film 5, a third positive electrode connection busbar and a fourth negative electrode connection busbar are soldered together, or a third negative electrode connection busbar and a fourth positive electrode connection busbar are soldered together.

In an implementation, by means of the soldering wires 5a in the carrier film 5, the third positive electrode connection busbar and the fourth negative electrode connection busbar are soldered together, and the third negative electrode connection busbar and the fourth positive electrode connection busbar are soldered together, and the soldering wire 5a which causes short circuiting is removed by laser.

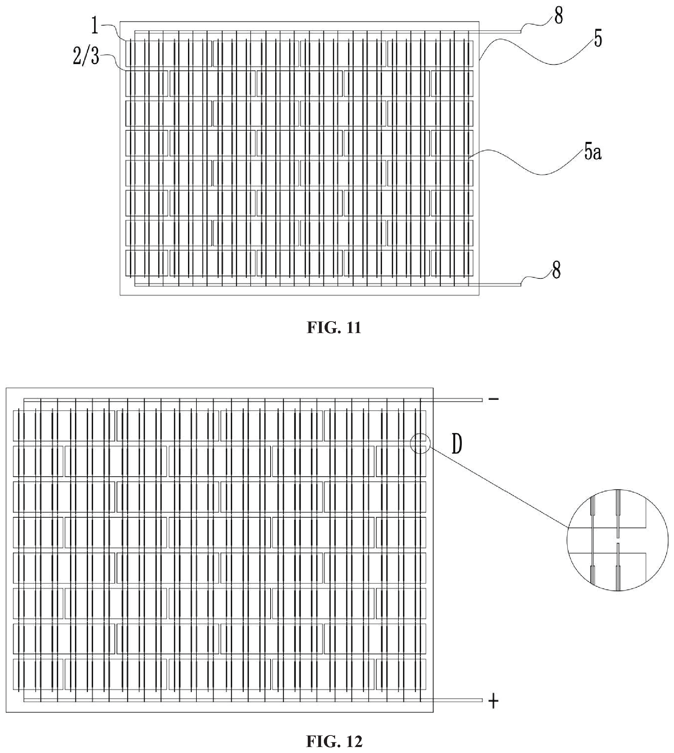

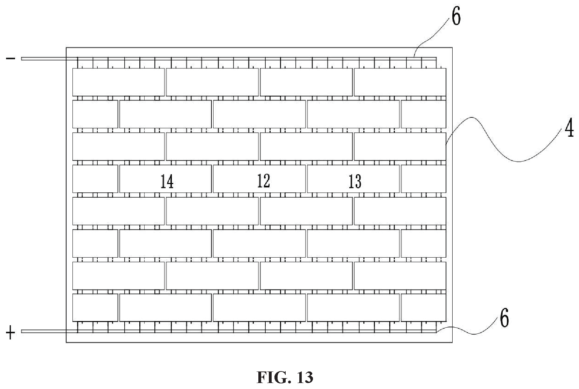

In an implementation, after the arrangement of the cells is completed, a circuit of the entire IBC cell assembly can be completed by roll-soldering the carrier film 5 without soldering the cells one by one, remarkably improving the efficiency. The IBC cell assembly in this implementation employs a misaligned matrix layout, so that the hot spots and power loss caused by shading the cells can be effectively reduced. As shown in FIG. 12, the soldering wire 5a causing short circuiting is cut apart by laser to form a complete assembly circuit, and the cut position D is shown in FIG. 12. For the IBC cells arranged in a misaligned matrix layout in this implementation, when some of the cells are shaded, for example, as shown in FIG. 13, when a first cell 12 is shaded, a current can flow through a second cell 13 and a third cell 14 without additional bypass diodes, so that hot spots are effectively avoided from being generated on the first cell 12, and the power loss of the IBC cell assembly is only a power generated by the shaded first cell 12. Compared with the IBC cell assembly in the prior art of FIG. 6, 50% of the power loss of the assembly is avoided in the same situation.

### Embodiment 3

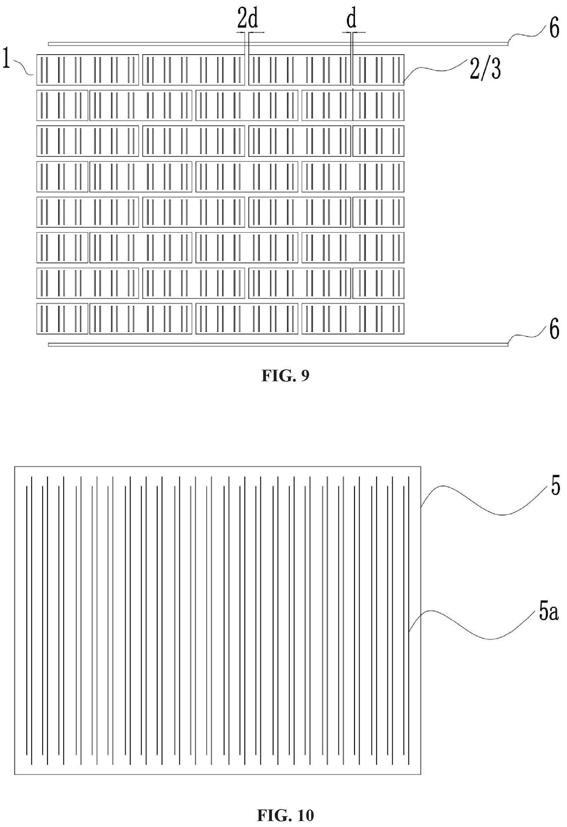

This embodiment provides an IBC cell assembly, as shown in FIG. 9, the IBC cell assembly includes an IBC cell array 4, where the IBC cell array 4 includes first cell row units and second cell row units, and the first cell row units and the second cell row units are arranged alternately in a longitudinal direction. The first cell row unit includes: N IBC cell bodies 1 of Embodiment 1 arranged in the transverse direction; and a first cell segment 2 or a second cell segment 3 arranged on one of two end sides of the N IBC cell bodies 1, and N is a positive integer greater than 2. The second cell row unit includes: N IBC cell bodies 1 rotated by 180° and arranged in the transverse direction; and a first cell segment 2 or a second cell segment 3 rotated by 180° and arranged on the other of the two end sides of the N IBC cell bodies 1. A distance between the IBC cell body 1 and the first cell segment 2 or the second cell segment 3 in the transverse direction is a second preset distance d, and a distance between the IBC cell bodies 1 in the transverse direction is a first preset distance 2d.

In an implementation, the IBC cell assembly includes positive electrodes and negative electrodes disposed on backlight surfaces of the IBC cell bodies 1, the first cell segments 2 and the second cell segments 3. The positive electrode includes a first positive electrode segment disposed in the first cell row unit, and a second positive electrode segment disposed in the second cell row unit adjacent to the first cell row unit. The negative electrode includes a first negative electrode segment in the first cell row unit, and a second negative electrode segment disposed in the second cell row unit adjacent to the first cell row unit. The first positive electrode segment includes multiple first positive electrode connection points for connection with soldering wires, and first positive electrode main grid lines for connecting adjacent first positive electrode connection points. The first negative electrode segment includes multiple first negative electrode connection points for connection with soldering wires, and first negative electrode main grid lines for connecting adjacent first negative electrode connection points. The second positive electrode segment includes multiple second positive electrode connection points for connection with soldering wires, and second positive electrode main grid lines for connecting adjacent second positive electrode connection points. The second negative electrode segment includes multiple second negative electrode connection points for connection with soldering wires, and second negative electrode main grid lines for connecting adjacent second negative electrode connection points. The first positive electrode main grid line and the second negative electrode main grid line coincide in an extension directions thereof. The first negative electrode main grid line and the second positive electrode main grid line coincide in the extension directions thereof.

In an implementation, the IBC cell assembly further includes busbars 6 disposed at the upper end and the lower end of the IBC cell array 4 in the transverse direction, respectively.

In an implementation, in the IBC cell assembly, the busbars 6 are soldered onto the first cell row units and the second cell row units to form a circuit by roll-soldering the carrier film 5 with the soldering wires 5a.

In an implementation, by means of the soldering wires 5a in the carrier film 5, a third positive electrode connection busbar and a fourth negative electrode connection busbar are soldered together, or a third negative electrode connection busbar and a fourth positive electrode connection busbar are soldered together.

In an implementation, by means of the soldering wires 5a in the carrier film 5, the third positive electrode connection busbar and the fourth negative electrode connection busbar are soldered together, and the third negative electrode connection busbar and the fourth positive electrode connection busbar are soldered together, and the soldering wire 5a which causes short circuiting is removed by laser.

In an implementation, after the arrangement of the cells is completed, a circuit of the entire IBC cell assembly can be completed by roll-soldering the carrier film 5 without soldering the cells one by one, remarkably improving the efficiency. The IBC cell assembly in this implementation employs a misaligned matrix layout, so that the hot spots and power loss caused by shading the cells can be effectively reduced. As shown in FIG. 12, the soldering wire 5a causing a short circuiting is cut apart by laser to form a complete assembly circuit, and the cut position D is shown in FIG. 12. For the IBC cells arranged in a misaligned matrix layout in this implementation, when some of the cells are shaded, for example, as shown in FIG. 13, when the first cell 12 is shaded, a current can flow through the second cell 13 and the third cell 14 without additional bypass diodes, so that the hot spots are effectively avoided from being generated on the first cell 12, and the power loss of the IBC cell assembly is only a power generated by the shaded first cell 12. Compared with the IBC cell assembly in the prior art of FIG. 6, 50% of the power loss of the assembly is avoided in the same situation.

### Embodiment 4

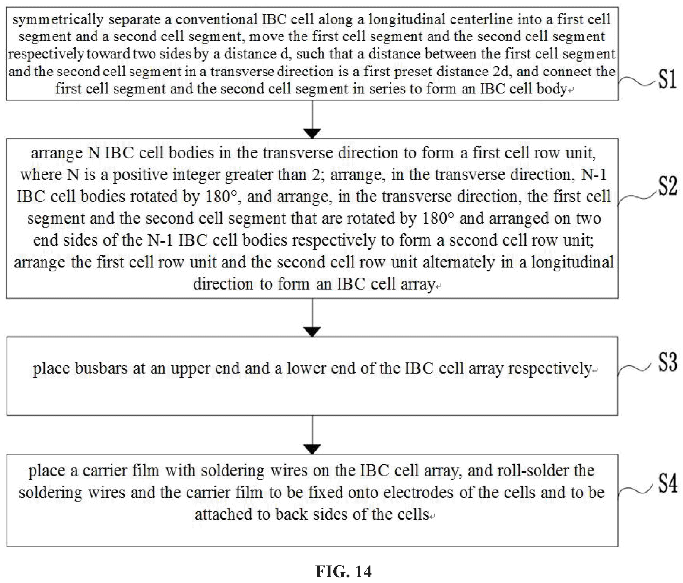

This embodiment provides a production method for an IBC cell assembly having the IBC cells of Embodiment 1. As shown in FIG. 14, the production method includes following S1 to S4:
in S1, a conventional IBC cell is symmetrically separated along a longitudinal centerline into a first cell segment 2 and a second cell segment 3, and the first cell segment 2 and the second cell segment 3 are moved respectively toward two sides by a distance d, such that a distance between the first cell segment 2 and the second cell segment 3 in a transverse direction is a first preset distance 2d, and the first cell segment 2 and the second cell segment 3 are connected in series to form an IBC cell body 1, where the first preset distance 2d is 2 times of a distance between a main grid line of a positive electrode and a main grid line of a negative electrode adjacent to the positive electrode;
in S2, N IBC cell bodies 1 are arranged in the transverse direction to form a first cell row unit, where N is a positive integer greater than 2; N-1 IBC cell bodies 1 rotated by 180° are arranged in the transverse direction, and the first cell segment 2 and the second cell segment 3 that are rotated by 180° and arranged on two end sides of the N-1 IBC cell bodies 1 respectively are arranged in the transverse direction to form a second cell row unit; the first cell row unit and the second cell row unit are arranged alternately in a longitudinal direction to form the IBC cell array 4, where a distance between the IBC cell body 1 and the first cell segment 2 or the second cell segment 3 in the transverse direction is a second preset distance d, and a distance between the IBC cell bodies 1 in the transverse direction is the first preset distance 2d;
in S3, busbars 6 are placed at the upper end and the lower end of the IBC cell array 4 respectively; and
in S4, a carrier film 5 with soldering wires 5a is placed on the IBC cell array 4, and the soldering wires 5a and the carrier film 5 are roll-soldered to be fixed onto the electrodes of the cells and to be attached to back sides of the cells.

In an implementation, in S4, the soldering wires 5a causing short circuiting are removed by laser.

In an implementation, in S4, the IBC cell array 4 is conveyed to a heated transport platform with foam-coated hot-pressing rollers.

### Embodiment 5

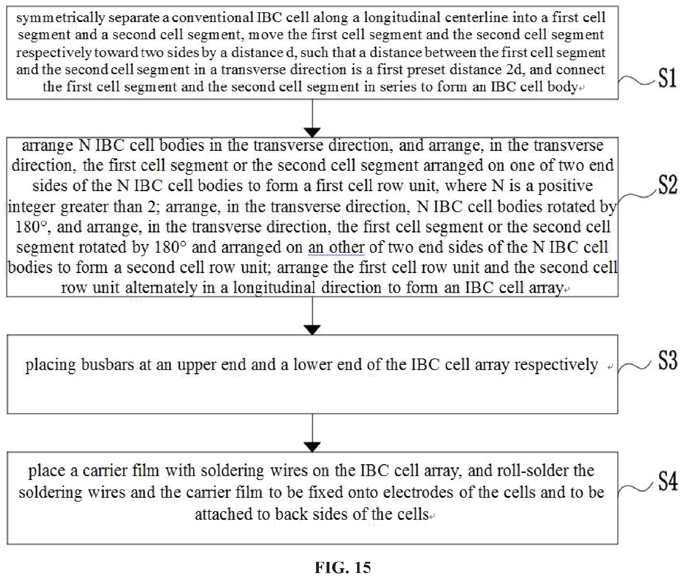

This embodiment provides a production method for an IBC cell assembly having the IBC cells of Embodiment 1. As shown in FIG. 15, the production method includes following S1 to S4:
in S1, a conventional IBC cell is symmetrically separated along a longitudinal centerline into a first cell segment 2 and a second cell segment 3, and the first cell segment 2 and the second cell segment 3 are moved respectively toward two sides by a distance d, such that a distance between the first cell segment 2 and the second cell segment 3 in a transverse direction is a first preset distance 2d, and the first cell segment 2 and the second cell segment 3 are connected in series to form an IBC cell body 1, where the first preset distance 2d is 2 times of a distance between a main grid line of a positive electrode and a main grid line of a negative electrode adjacent to the positive electrode;
in S2, N IBC cell bodies 1 are arranged in the transverse direction, and the first cell segment 2 or the second cell segment 3 arranged on one of two end sides of an assembly of the N IBC cell bodies 1 is arranged in the transverse direction to form a first cell row unit, where N is a positive integer greater than 2; N IBC cell bodies 1 rotated by 180° are arranged in the transverse direction, and the first cell segment 2 or the second cell segment 3 rotated by 180° and arranged on the other of the two end sides of the N IBC cell bodies 1 is arranged in the transverse direction to form a second cell row unit; and the first cell row unit and the second cell row unit are arranged alternately in a longitudinal direction to form the IBC cell array 4, where a distance between the IBC cell body 1 and the first cell segment 2 or the second cell segment 3 in the transverse direction is a second preset distance d, and a distance between the IBC cell bodies 1 in the transverse direction is the first preset distance 2d;
in S3, busbars 6 are placed at the upper end and the lower end of the IBC cell array 4 respectively; and
in S4, a carrier film 5 with soldering wires 5a is placed on the IBC cell array 4, and the soldering wires 5a and the carrier film 5 are roll-soldered to be fixed onto the electrodes of the IBC cells and to be attached to back sides of the IBC cells.

In an implementation, in S4, the soldering wires 5a causing short circuiting are removed by laser.

In an implementation, in S4, the IBC cell array 4 is conveyed to a heated transport platform with foam-coated hot-pressing rollers.

The undescribed components in the present disclosure belongs to the prior art.

In the present disclosure, the principle and implementations of the present disclosure are described herein by using specific examples, the above descriptions of the above embodiments are merely intended to help understand the methods and core idea of the disclosure; and meanwhile, for those of ordinary skill in the art, changes may be made to the specific embodiments and the scope of application according to the concept of the present disclosure. In summary, the content of the description should not be construed as a limitation to the present disclosure.

## Claims

1. An interdigitated back contact (IBC) cell, comprising: an IBC cell body (1), and positive electrodes and negative electrodes that are disposed on a backlight surface of the IBC cell body (1), the IBC cell body (1) comprising a first cell segment (2), a rectangular transition zone and a second cell segment (3), the first cell segment (2) and the second cell segment (3) being distributed on two sides of the rectangular transition zone respectively and arranged mirror-symmetrically with respect to the rectangular transition zone as an axis of symmetry, a length of the rectangular transition zone in a transverse direction being a first preset distance 2d, the positive electrodes and the negative electrodes being disposed on backlight surfaces of the first cell segment (2) and the second cell segment (3), and each of the positive electrodes and the negative electrodes having main grid lines, wherein the first preset distance 2d is 2 times of a distance between a main grid line of one of the positive electrodes and a main grid line of one of the negative electrodes adjacent to the one of the positive electrodes.

2. An IBC cell assembly having the IBC cell of claim 1, wherein the IBC cell assembly comprises an IBC cell array (4), the IBC cell array (4) comprises first cell row units and second cell row units arranged alternately in a longitudinal direction, each of the first cell row units comprises N IBC cell bodies (1) arranged in the transverse direction, wherein N is a positive integer greater than 2, and each of the second cell row units comprises: N-1 IBC cell bodies (1) rotated by 180° and arranged in the transverse direction; and the first cell segment (2) and the second cell segment (3) that are rotated by 180° and arranged on two end sides of the N-1 IBC cell bodies (1) respectively; wherein a distance between an IBC cell body (1) and the first cell segment (2) or the second cell segment (3) in the transverse direction is a second preset distance d, and a distance between IBC cell bodies (1) in the transverse direction is a first preset distance 2d.

3. An IBC cell assembly having the IBC cell of claim 1, wherein the IBC cell assembly comprises an IBC cell array (4), the IBC cell array (4) comprises first cell row units and second cell row units arranged alternately in a longitudinal direction, each of the first cell row units comprises: N IBC cell bodies (1) arranged in a transverse direction; and the first cell segment (2) or the second cell segment (3) arranged on one of two end sides of the N IBC cell bodies (1), wherein N is a positive integer greater than 2, and each of the second cell row units comprises: N IBC cell bodies (1) rotated by 180° and arranged in the transverse direction; and the first cell segment (2) or the second cell segment (3) rotated by 180° and arranged on an other of two end sides of the N IBC cell bodies (1); wherein a distance between an IBC cell body (1) and the first cell segment (2) or the second cell segment (3) in the transverse direction is a second preset distance d, and a distance between IBC cell bodies (1) in the transverse direction is a first preset distance 2d.

4. The IBC cell assembly according to claim 2 or 3, wherein each of the positive electrodes comprises first positive electrode segments disposed in the first cell row units, and second positive electrode segments disposed in the second cell row units adjacent to the first cell row units; each of the negative electrodes comprises first negative electrode segments in the first cell row units, and second negative electrode segments disposed in the second cell row units adjacent to the first cell row units; each of the first positive electrode segments comprises a plurality of first positive electrode connection points for connection with soldering wires, and first positive electrode main grid lines for connecting adjacent first positive electrode connection points; each of the first negative electrode segments comprises a plurality of first negative electrode connection points for connection with soldering wires, and first negative electrode main grid lines for connecting adjacent first negative electrode connection points; each of the second positive electrode segments comprises a plurality of second positive electrode connection points for connection with soldering wires, and second positive electrode main grid lines for connecting adjacent second positive electrode connection points; each of the second negative electrode segments comprises a plurality of second negative electrode connection points for connection with soldering wires, and second negative electrode main grid lines for connecting adjacent second negative electrode connection points; and each of the first positive electrode main grid lines and a corresponding one of the second negative electrode main grid lines coincide in extension directions thereof, and each of the first negative electrode main grid lines and a corresponding one of the second positive electrode main grid lines coincide in extension directions thereof.

5. The IBC cell assembly according to claim 4, wherein the IBC cell assembly further comprises busbars (6) disposed at an upper end and a lower end of the IBC cell array (4) in the transverse direction.

6. The IBC cell assembly according to claim 5, wherein in the IBC cell assembly, the busbars (6) are soldered onto the first cell row units and the second cell row units to form a circuit by roll-soldering a carrier film (5) with soldering wires (5a).

7. The IBC cell assembly according to claim 6, wherein by means of the soldering wires (5a) in the carrier film (5), a third positive electrode connection busbar and a fourth negative electrode connection busbar are soldered together, or a third negative electrode connection busbar and a fourth positive electrode connection busbar are soldered together.

8. The IBC cell assembly according to claim 6, wherein by means of the soldering wires (5a) in the carrier film (5), the third positive electrode connection busbar and the fourth negative electrode connection busbar are soldered together, and the third negative electrode connection busbar and the fourth positive electrode connection busbar are soldered together, and some of the soldering wires (5a) which causes short circuiting are removed by laser.

9. A production method for an IBC cell assembly having the IBC cell of claim 1, wherein the production method comprises:
S1, symmetrically separating a conventional IBC cell along a longitudinal centerline into a first cell segment (2) and a second cell segment (3), moving the first cell segment (2) and the second cell segment (3) respectively toward two sides by a distance d, such that a distance between the first cell segment (2) and the second cell segment (3) in a transverse direction is a first preset distance 2d, and connecting the first cell segment (2) and the second cell segment (3) in series to form an IBC cell body (1), wherein the first preset distance 2d is 2 times of the distance between a main grid line of one of positive electrodes and a main grid line of one of negative electrodes adjacent to the one of the positive electrodes;
S2, arranging N IBC cell bodies (1) in the transverse direction to form a first cell row unit, wherein N is a positive integer greater than 2; arranging, in the transverse direction, N-1 IBC cell bodies (1) rotated by 180°, and arranging, in the transverse direction, the first cell segment (2) and the second cell segment (3) that are rotated by 180° and arranged on two end sides of the N-1 IBC cell bodies (1) respectively to form a second cell row unit; arranging the first cell row unit and the second cell row unit alternately in a longitudinal direction to form an IBC cell array, wherein a distance between the IBC cell body (1) and the first cell segment (2) or the second cell segment (3) in the transverse direction is a second preset distance d, and a distance between IBC cell bodies (1) in the transverse direction is the first preset distance 2d;
S3, placing busbars (6) at an upper end and a lower end of the IBC cell array (4) respectively; and
S4, placing a carrier film (5) with soldering wires (5a) on the IBC cell array (4), and roll-soldering the soldering wires (5a) and the carrier film (5) to be fixed onto electrodes of the cells and to be attached to back sides of the cells.

10. A production method for an IBC cell assembly having the IBC cell of claim 1, wherein the production method comprises:
S1, symmetrically separating a conventional IBC cell along a longitudinal centerline into a first cell segment (2) and a second cell segment (3), moving the first cell segment (2) and the second cell segment (3) respectively toward two sides by a distance d, such that a distance between the first cell segment (2) and the second cell segment (3) in a transverse direction is a first preset distance 2d, and connecting the first cell segment (2) and the second cell segment (3) in series to form an IBC cell body (1), wherein the first preset distance 2d is 2 times of a distance between a main grid line of one of positive electrodes and a main grid line of one of negative electrodes adjacent to the one of the positive electrodes;
S2, arranging N IBC cell bodies (1) in the transverse direction, and arranging, in the transverse direction, the first cell segment (2) or the second cell segment (3) arranged on one of two end sides of the N IBC cell bodies (1) to form a first cell row unit, wherein N is a positive integer greater than 2; arranging, in the transverse direction, N IBC cell bodies (1) rotated by 180°, and arranging, in the transverse direction, the first cell segment (2) or the second cell segment (3) rotated by 180° and arranged on an other of two end sides of the N IBC cell bodies (1) to form a second cell row unit; arranging the first cell row unit and the second cell row unit alternately in a longitudinal direction to form an IBC cell array, wherein a distance between the IBC cell body (1) and the first cell segment (2) or the second cell segment (3) in the transverse direction is a second preset distance d, and a distance between IBC cell bodies (1) in the transverse direction is the first preset distance 2d;
S3, placing busbars (6) at an upper end and a lower end of the IBC cell array (4) respectively; and
S4, placing a carrier film (5) with soldering wires (5a) on the IBC cell array (4), and roll-soldering the soldering wires (5a) and the carrier film (5) to be fixed onto electrodes of the cells and to be attached to back sides of the cells.

11. The production method according to claim 9 or 10, wherein in S4, some of the soldering wires (5a) causing short circuiting are removed by laser.

12. The production method according to claim 11, wherein in S4, the IBC cell array (4) is conveyed to a heated transport platform with foam-coated hot-pressing rollers.
